# EUROPEAN PATENT APPLICATION

(11) **EP 4 407 852 A1**
(43) Date of publication of application: **31.07.2024**
(21) Application number: 22872592.5
(22) Date of filing: 12.08.2022
(51) Int. Cl.: H02M 3/155, B60R 16/033, H02J 7/02

(54) **VEHICLE POWER SUPPLY DEVICE**

(30) Priority: 24.09.2021 JP 2021155218
(71) Applicant: Imasen Electric Industrial Co., Ltd., Inuyama-shi, Aichi 484-8507 (JP)
(72) Inventor: YAMANOUE, Koichi, Inuyama-shi, Aichi 484-8507 (JP); HATTORI, Makoto, Inuyama-shi, Aichi 484-8507 (JP)
(74) Representative: Grünecker Patent- und Rechtsanwälte PartG mbB
(86) International application number: PCT/JP2022/030716
(87) International publication number: WO 2023/047836

(57) **Abstract**

[Subject Matter]

To provide a vehicle power supply device capable of balancing the upper battery and the lower battery.

[Solution(s)]

The vehicle power supply device has an upper battery E1 on the high voltage side, a lower battery E2 connected to the earth side, a connection point CP between the upper and lower batteries, and FET 1 and FET 2 that supply electric power to the upper and lower batteries E1 and E2 by PID control 50. And furthermore, a feedback control 60 with a longer time than the I (integral control) 38 of the PID control 50 is added.

## Description

### TECHNICAL FIELD

The present invention relates to a vehicle power supply device that supplies multiple voltages via a divided battery.

### BACKGROUND ART

Patent publication 1 discloses a vehicle power supply device which performs power conversion by selectively connecting storage batteries to a low voltage power load from a high voltage power supply formed by connecting the storage batteries in series.

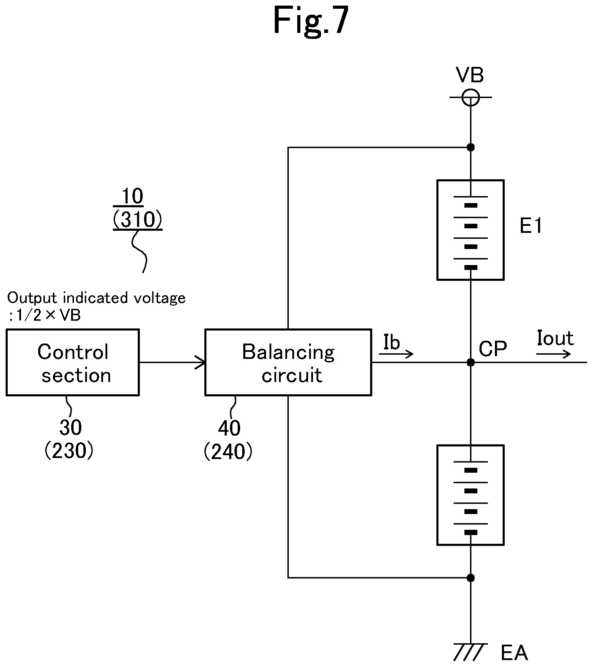

Fig. 7 shows a conventional vehicle power supply device310.

The battery is divided into an upper battery E1 connected to the high voltage VB side and a lower battery E2 connected to the earth EA side. A current Iout is output from the connection point CP between the upper battery E1 and the lower battery E2. High voltage is supplied from the high voltage VB side. The upper battery E1 and the lower battery E2 are charged by the balancing circuit 240. The balance circuit 240 is controlled by the control unit 230.

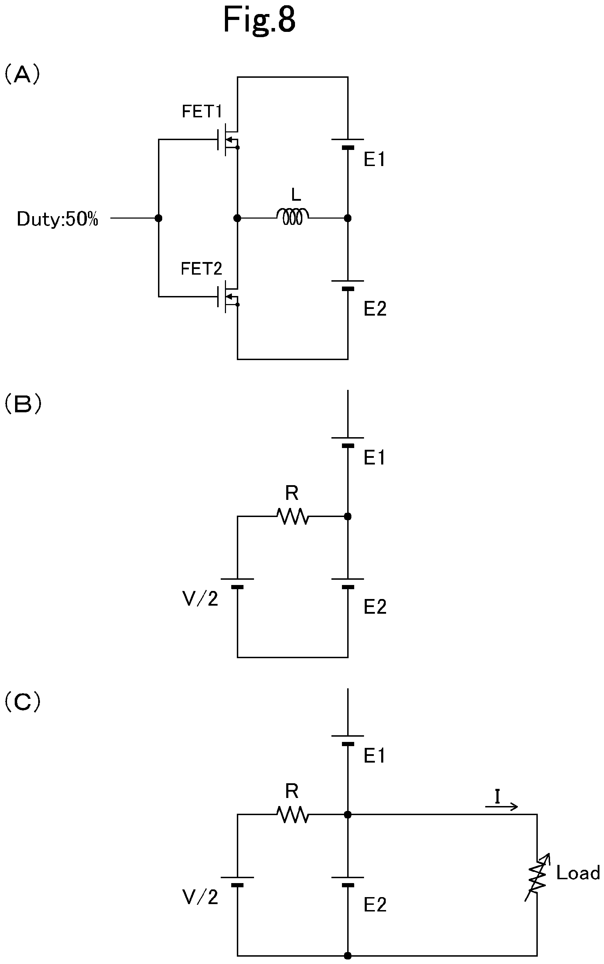

Fig. 8(A) shows the equivalent circuit of the balance circuit, upper battery E1 and lower battery E2 in Fig. 7. a control signal of 50% duty is applied to FET1 and FET2, FET1 charges upper battery E1 via coil L and FET2 charges lower battery E2 via coil L.

The circuit configuration in Fig. 8(A) is equivalent to that shown in Fig. 8(B). In other words, it is equivalent to the configuration with an ideal power supply of V/2 and an output impedance R.

The configuration in Fig. 8(B) is equivalent to the configuration shown in Fig. 8(C). Here, when the load current I is applied to the load, the upper battery E1 becomes [V/2+IR] and the lower battery E2 becomes [V/2-IR], which is unbalanced.

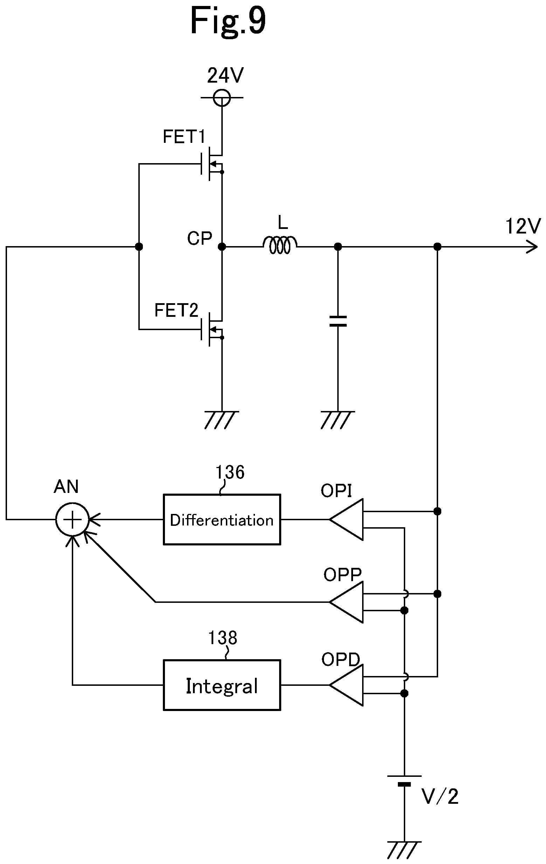

. Fig. 9 shows the configuration of a conventional technology DCDC converter in which P (proportional control) I (integral control) D (derivative control) control is applied to FET1 and FET2. The output voltage of 12 V from the connection point CP of FET1 and FET2 is compared with a reference voltage of V/2 by the operational amplifier OPI, differentiated by the differentiation circuit 136 and added to the addition node AN. Similarly, the output voltage of 12 V is compared with the reference voltage of V/2 with the operational amplifier OPP and added to the addition node AN. The output voltage of 12 V is compared with the reference voltage of V/2 with the operational amplifier OPD, integrated with the integration circuit 138 and added to the addition node AN. The output from the addition node AN is fed back to FET1 and FET2.

Fig. 10 shows the input voltage (10(A)), output current (10(B)) and output voltage (Fig. 10(C)) of the circuit shown in Fig. 9. The output voltage drops during overcurrent when the current exceeds the current limit of the DCDC converter.

Fig. 11(A) shows the circuit shown in Fig. 8(A) with P (proportional control) I (integral control) D (derivative control) control shown in Fig. 9.

### PRIOR ART PUBLICATION

### PATENT PUBLICATION

Patent Publication (1): Japanese Laid-Open Patent Publication No. 2018-26973

### SUMMARY OF THE INVENTION

### PROBLEM(S) TO BE SOLVED BY THE INVENTION

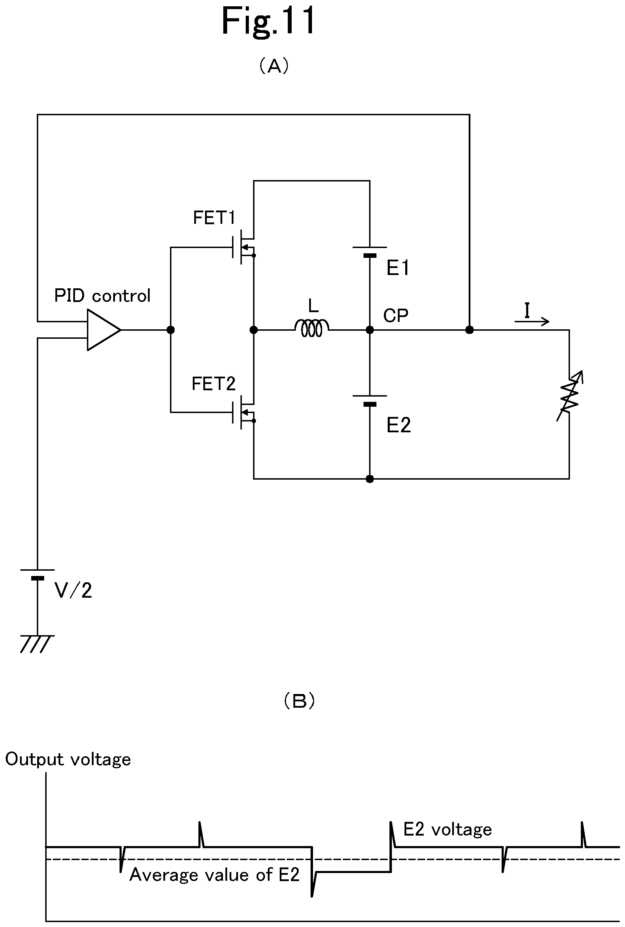

In the vehicle power supply device, for example, when the motor of the electric power steering is rapidly rotated, a case arises in which an output current higher than the specified output current is generated. In such cases, as shown in Fig. 11(B), which represents the output current of the configuration in Fig. 11(A), the voltage of the lower battery E2, indicated by the solid line, will fall below the average voltage of the lower battery E2, indicated by the broken line. That is, in real-time P (proportional control) I (integral control) D (differential control) control, the voltage of the lower battery E2 decreases (lower by ΔV [IR in Fig. 8(C)] than 2/V) and the voltage of the upper battery E 1 increases (higher by ΔV than 2/V) due to the voltage application time of the batteries and the chemical reaction delay time The balance between the upper battery and the lower battery becomes unbalanced, the battery is depleted and its life is shortened.

The object of the present invention is to provide a vehicle power supply device that can balance the upper battery and the lower battery.

### SOLUTION(S) TO THE PROBLEM(S)

The present invention is a vehicle power supply device, comprising: a battery divided into an upper battery on a high voltage side and a lower battery on a low voltage side; and a DC-DC converter for suppling power to the upper battery and the lower battery within preset output limits; wherein a feedback control is added to feed back a difference between a long-term average value of an output of said DC-DC converter and a target value.

### EFFECT(S) OF THE INVENTION

The integral term of the I (integral control) of the P (proportional control) I (integral control) D (derivative control) control of conventional technology is set to keep the output electric value pressure at the output indicated voltage at the present time. Therefore, if the time constant of the integral term of the I (integral control) of the P (proportional control) I (integral control) D (differential control) control of conventional technology is increased, the response to the target indicated voltage becomes poor and a voltage different from the voltage value to be output is output.

The vehicle power supply in Claim 1, long time feedback control is added. This allows the control to balance the battery over a long period of time.

The vehicle power supply device in Claim 2, wherein a feedback control of a longer time than the I (integral control) control of the PID control is further added to the power supply circuit that supplies power by P (proportional control) I (integral control) D (differential control) control. Therefore, when viewed over a short period of time, the output voltage is almost the same as the target output voltage, and when viewed over a long period of time, the control can be performed to balance the battery.

Furthermore, with only real-time P (proportional control) I (integral control) D (derivative control) control, the voltage of the lower battery is reduced and the balance between the upper and lower batteries becomes unbalanced due to the time of voltage application and chemical reaction delay in the battery. However, feedback control for a longer time than the I (integral control) control of PID control is added. By this, corresponding the voltage application time of the battery to the delay time of the chemical reaction and balancing the upper and lower batteries reduces battery depletion and extends battery life.

The vehicle power supply in Claim 3 adds the difference between the long-term average value of the output of the DC-DC converter and the target value to the input side of the DC-DC converter in feedback control. Therefore, when viewed over a short period of time, the output voltage is almost the same as the target output voltage, and when viewed over a long period of time, the control can be performed to balance the battery.

The vehicle power supply in Claim 4, where the voltage of the upper and lower batteries is almost equal, so the power supply circuit can charge the upper and lower batteries with a simple 50-50 duty.

The vehicle power supply in Claim 5, wherein the voltage of the upper battery is higher than the voltage of the lower battery. The power supply circuit can charge the upper battery and the lower battery by adjusting the duty ratio to the voltage.

The vehicle power supply device in Claim 6 can accurately determine the average over a long period of time, e.g. one hour, because the average over a long period of time is determined by an arithmetical process, and the battery voltage application time and the delay time of the chemical reaction can be matched and balanced between the upper and lower batteries to reduce battery depletion and extend battery life.

### BRIEF DESCRIPTION OF THE DRAWINGS

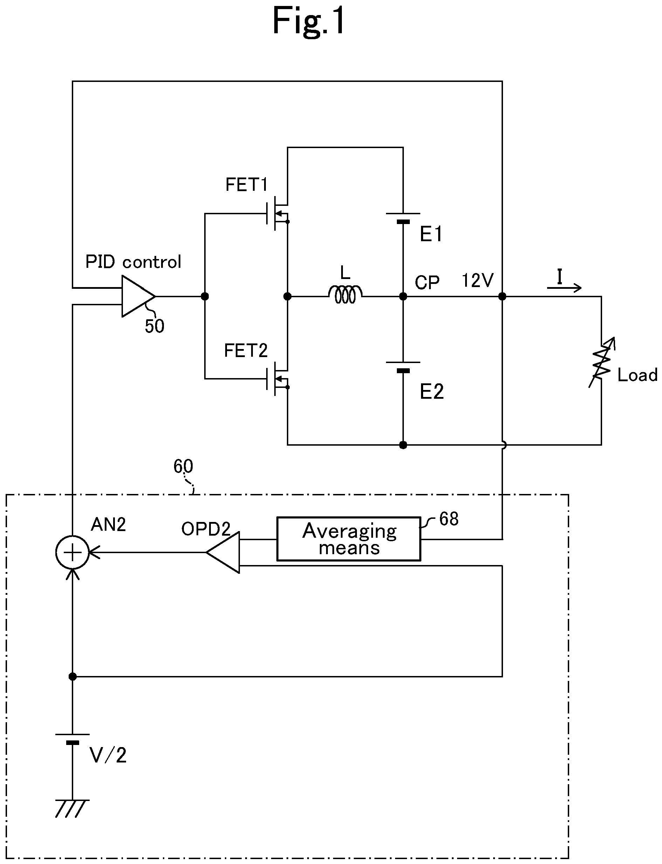

[Fig. 1] a diagram showing the equivalent circuit of the balance circuit, upper battery and lower battery of the vehicle power supply of the first embodiment of the present invention;

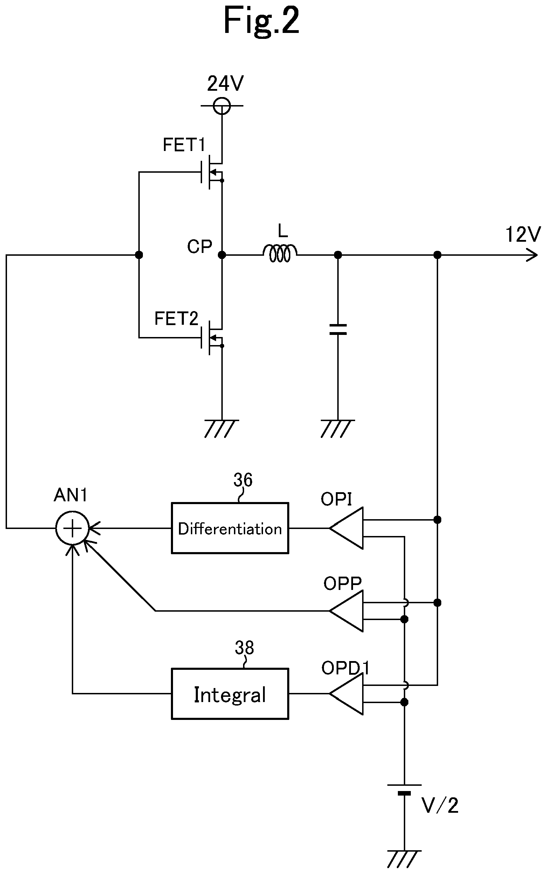

[Fig. 2] a diagram showing the contents of the PID control of the vehicle power supply device of the first embodiment;

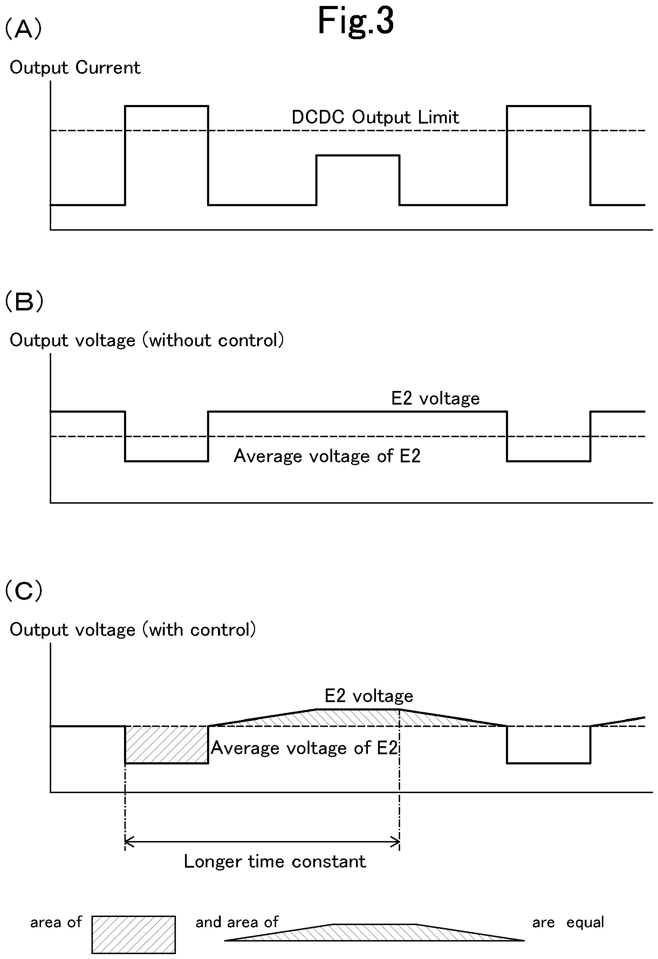

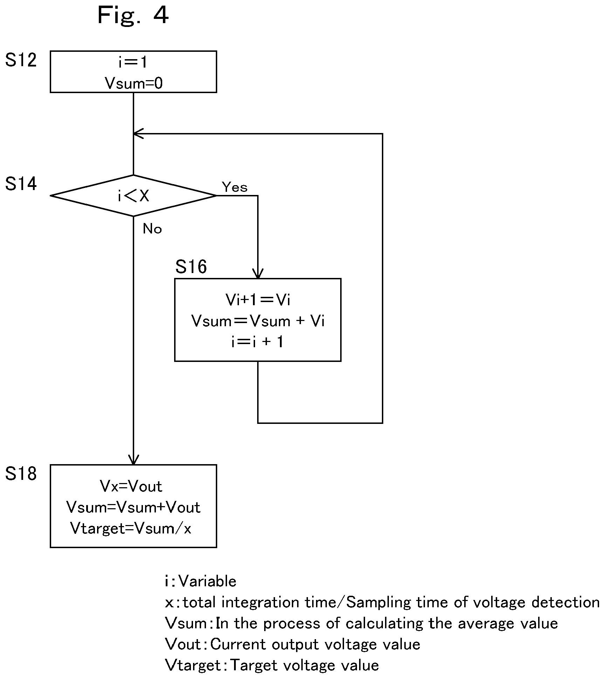

[Fig. 3] Fig. 3 (A) shows the output current of the vehicle power supply of the first embodiment, Fig. 3 (B) shows the output voltage when integral control with a long time constant is not added and Fig. 3 (C) shows the output voltage when integral control with a long time constant is added; [Fig. 4] a flowchart showing the processing in the integrating circuit;

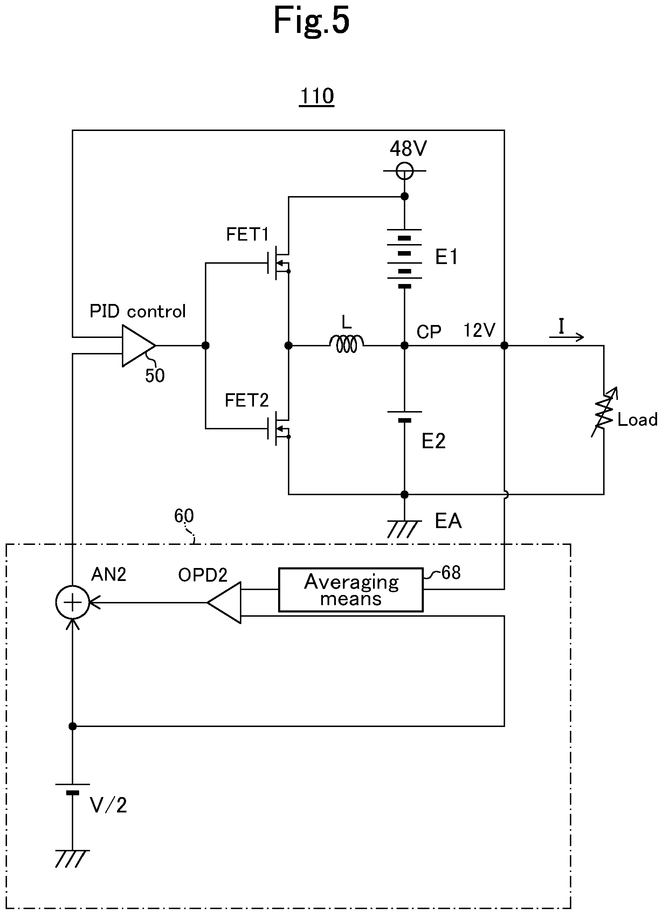

[Fig. 5] a circuit diagram of a vehicle power supply device for a modified example of the first embodiment of the present invention;

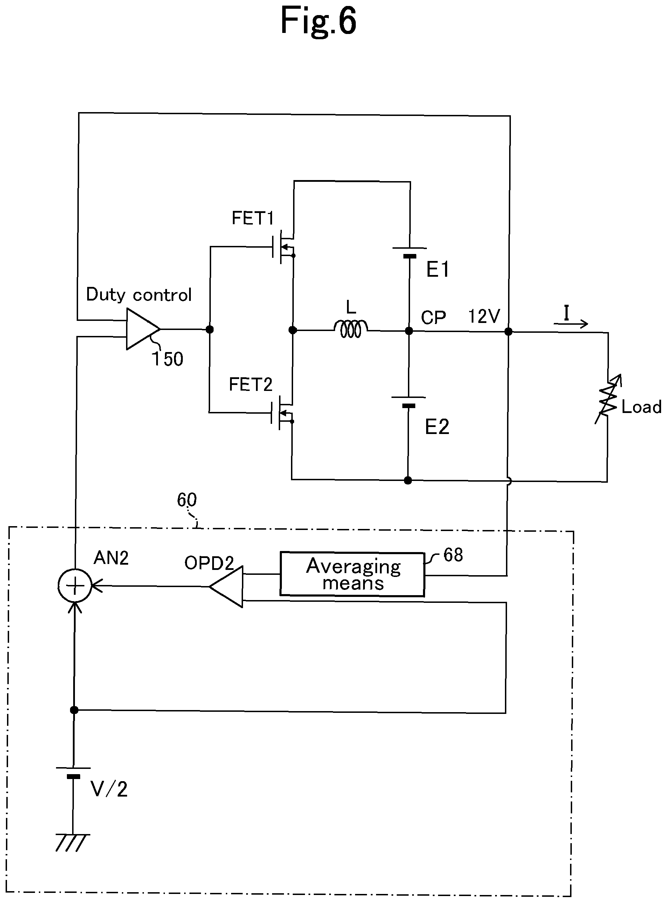

[Fig. 6] a circuit diagram of the vehicle power supply device of the second embodiment;
[Fig. 7] a diagram of the vehicle power supply device of the first embodiment and the conventional technology;
[Fig. 8] a diagram showing the equivalent circuits of the balance circuit, upper battery and lower battery of the conventional technology vehicle power supply;
[Fig. 9] a diagram showing the configuration of a DCDC converter of conventional technology in which PID control is applied to the FET;

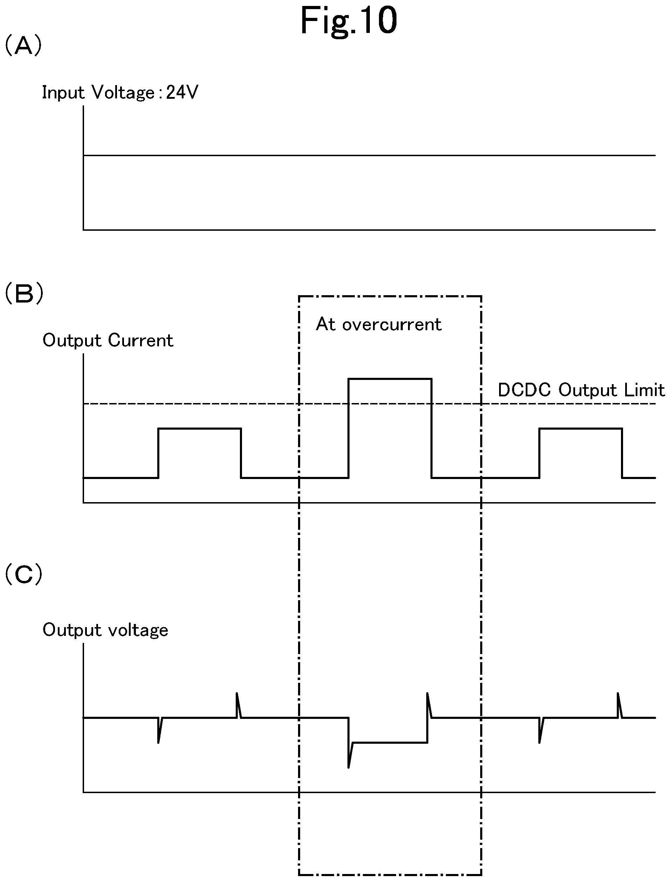

[Fig. 10] Fig. 10 (A) shows the input voltage, Fig. 10 (B) shows the output current and Fig . 10 (C) shows the output voltage of the circuit shown in Fig. 9; and
[Fig. 11] Fig. 11(A) shows the configuration of a conventional technology DCDC converter and Fig. 11(B) shows the output voltage of the DC-CD converter in Fig. 11(A).

### MODE TO CARRY OUT THE INVENTION

### [First embodiment]

Fig. 7 shows the configuration of the vehicle power supply device 10 of the first embodiment.

The battery is divided into an upper battery E 1 connected to the 24V high voltage VB side and a lower battery E2 connected to the ground EA side. The voltage of the upper battery E 1 and the voltage of the lower battery E2 are both 12V. A current Iout of 12V is output from the connection point CP between the upper battery E1 and the lower battery E2. A high voltage of 24V is supplied from the high voltage VB side. The upper battery E1 and lower battery E2 are charged by the balance circuit 40. The balance circuit 40 is controlled by the control unit 30. The control unit 30 and the balance circuit 40 constitute a DC-DC converter.

The control unit 30 applies a current limit to the output current Iout to prevent the output current exceeding the preset rated output capacity from flowing for a long time and to operate safely in the event of an output error. That is, when the control section 30 monitors the output current (current Iout) and detects an abnormal current, it applies a current limit so that no more output current flows. The output current exceeding the rated output capacity flows only for a very short time during the entire time. For example, when electric power steering is operated to the locked state, a large output current flows for a very short time (about 2 seconds). It is assumed that the locking state of electric power steering occurs almost infrequently, at most once per hour.

Fig. 1 shows the equivalent circuits of the balance circuit, upper battery E1, and lower battery E2 in Fig. 7. A control signal of 50% duty is applied to FET1 and FET2, FET1 charges upper battery E1 via coil L, and FET2 charges lower battery E2 via coil L.

On the input side of FET1 and FET2, there is a PID control 50 that performs P (proportional control) I (integral control) D (derivative control) control. the contents of the PID control are shown in Fig. 2. the output voltage of 12V from the connection point CP of FET1 and FET2 is compared with the reference voltage of V/2 by the op amp OPI and differentiated by the differential circuit 3 6 differentiates it and adds it to the first addition node AN1. Similarly, the output voltage of 12 V is compared with the reference voltage of V/2 by the operational amplifier OPP and added to the first addition node AN1. 12 V output voltage is compared with the reference voltage of V/2 by the first operational amplifier OPD1, integrated by the integrating circuit 38, and added to the first addition node AN1. The output from the first addition node AN1 is fed back to FET1 and FET2.

In the vehicle power supply device 10 of the first embodiment, in addition to the PID control 50, a feedback control 60 by averaging means 68 is added to the PID control 50 to obtain an average value over a longer time than the I control by the integration circuit 38. The averaging time of the averaging means 68 is suitably at least 10 times longer than the time constant of the integral circuit 38, and 100 times longer is even more desirable.

The averaging means 68 determines the average value over a longer time than the I control by the integration circuit 38 of the PID control 50, the determined average value is compared with the reference voltage (target value) of V/2 and the second operational amplifier OPD2, and the difference is added to the second addition node AN2. The output from the second addition node AN2 is added to one input terminal of the PID control 50. 12V output voltage is added to the other input terminal of the PID control 50.

Fig. 3(A) shows the output current of the first embodiment, Fig. 3(B) shows the output voltage when feedback control is not added, and Fig. 3(C) shows the output voltage when feedback control is added.

When the feedback control shown in Fig. 3(B) is not added, when the output current exceeds the current limit of the vehicle power supply, the control unit 30, which monitors the output current (current Iout) as described above, detects an abnormal current and applies a current limit to prevent further output current flow. This causes the voltage of the lower battery E2, indicated by the solid line, to fall below the average voltage of the lower battery E2, indicated by the dashed line.

When the feedback control shown in Fig. 3(C) is added, when the output current exceeds the current limit of the vehicle power supply, the voltage of the lower battery E2 shown by the solid line becomes lower than the average voltage of the lower battery E2 shown by the dashed line. However, when the output current is within the current limit, the voltage of the lower battery E2 shown by the solid line exceeds the average voltage of the lower battery E2 shown by the dashed line for a while. That is, the area of the rectangle where the voltage of the lower battery E2 indicated by the solid line becomes lower than the average voltage of the lower battery E2 indicated by the dashed line is equal to the area of the trapezoid where the voltage of the lower battery E2 indicated by the solid line exceeds the average voltage of the lower battery E2 indicated by the dashed line.

The integral term of I (integral control) in the P (proportional control) I (integral control) D (derivative control) control of the conventional technology is set to keep the output electric value pressure at the current output indicated voltage. Therefore, if the time constant of the integral term of the I (integral control) of the P (proportional control) I (integral control) D (derivative control) control of the conventional technology is increased, the response to the target indicated voltage becomes poor and a voltage different from the desired output voltage value is output.

In the vehicle power supply device 10 of the first embodiment, the power supply circuits (FET1 and FET2) that supply power by P (proportional control) I (integral control) D (derivative control) control are further added with feedback control 60 by averaging means 68 for a longer time than the I control of the integral circuit 38 of the PID control. Thus, when viewed over a short period of time, the output voltage is almost the same as the target output voltage, and when viewed over a long period of time, the control can be performed to balance the batteries. Furthermore, the addition of feedback control for a longer time than the I (integral control) control of PID control reduces battery depletion and extends battery life by balancing the upper and lower batteries, corresponding to the voltage application time of the battery and the delay time of the chemical reaction.

Here, it is possible to set a capacity sufficiently larger than the output current used in the DC-DC converter, i.e., to maintain the average voltage by enhancing the hardware to eliminate the output voltage drop. However, increasing the output capacity of the DC-DC converter would make the vehicle power supply larger and more expensive. In contrast, the vehicle power supply device 10 of the first embodiment can balance the battery over the long term by feedback control, reduce battery depletion, and extend the battery utilization time.

Fig. 4 is a flowchart showing the process in the averaging means 68, which is composed of a microcontroller (digital circuit).

In step 12, variable i is set to 1 and Vsum, which is in the process of calculating the average, is initialized to 0.

In step 14, it is determined whether variable i is less than the total integration time x. For example, 1 hour is set as the total integration time. If variable i is smaller than the total integration time x (S14: Yes), move to step 16.

In step 16, 1 is added to Vi and Vsum is set to Vsum + Vi, i.e., the current voltage value Vi is added to the previous Vsum. 1 is added to variable i. In step 16, the previous voltage value data from V1 to Vx are shifted and the total is calculated.

In step 14, it is determined whether variable i is less than the total integration time x. If variable i is greater than or equal to the total integration time x (S14: No), the process moves to Step 18.

In step 18, Vx is set to Vout (the current output voltage value), Vsum in the process of calculating the average value is set to Vsum + Vout, and the target voltage value Vtarget is obtained as Vsum/x by adding the voltage values for x. In other words, the latest voltage values are summed and the average value is calculated.

The vehicle power supply of the first embodiment can reduce battery depletion and extend battery life by balancing the upper and lower batteries by making the added feedback control correspond to the voltage application time of the battery and the delay time of the chemical reaction, because the added feedback control is a long-time average control.

In the vehicle power supply device of the first embodiment, since the long-time average value is obtained by arithmetic processing, for example, the average over a long time period of about one hour can be accurately obtained, and the battery's voltage application time and the delay time of chemical reaction are made to correspond to each other, and by balancing the upper battery and the lower battery, battery depletion can be reduced and battery life can be extended.

In the first embodiment of the vehicle power supply system, the voltage of the upper battery E 1 and the lower battery E2 are almost equal, so the power circuit can charge the upper and lower batteries with a simple 50-50 duty cycle.

### [Example of modification of the first embodiment]

Fig. 5 shows the configuration of the vehicle power supply 110 for a modified example of the first embodiment.

The battery is divided into an upper battery E 1 connected to the 48V high voltage VB side and a lower battery E2 connected to the ground EA side. The voltage of the upper battery E 1 is 36 V and that of the lower battery E2 is 12 V. A current Iout of 12V is output from the connection point CP between the upper battery E1 and the lower battery E2. A high voltage of 48V is supplied from the high voltage VB side. The upper battery E1 and lower battery E2 are charged by PID control 50. 25% duty control signal is applied to FET1 to charge the upper battery E1 via coil L. 75% duty control signal is applied to FET2 to charge the lower battery E2 via coil L.

In the vehicle power supply device for the modified example of the first embodiment, the voltage of the upper battery E1 is higher than that of the lower battery E2; by adjusting the duty ratio of FET1 and FET2 to match the voltage, the upper battery E 1 and lower battery E2 can be charged.

### [Second embodiment]

Fig. 6 shows the second embodiment of the vehicle power supply 210.

Due to duty control 150, a 50% duty signal is applied to FET1, and the upper battery E1 is charged via coil L. The duty control 150 causes a 50% duty signal to be applied to FET2, charging the lower battery E2 via coil L.

An average value is obtained by averaging means 68, which averages over a long period of time in feedback control 60, the obtained average value is compared with the reference voltage (target value) of V/2 by the second operational amplifier OPD2, and the difference is added to the second addition node AN2. Based on the difference, the duty control 150 adds/subtracts a 50% duty signal to FET1 and a 50% duty signal to FET2, so that the battery can be controlled to balance even over a long period of time.

### DESCRIPTION OF NUMERICAL REFERENCES

- 10: Vehicle power supply device
- 36: Differentiation circuit
- 38: Integral circuit
- 50: PID control
- 60: Feedback control
- 68: Averaging means
- EA: Ground
- VB: High voltage
- E1: Upper battery
- E2: Lower batter

## Claims

1. A vehicle power supply device, comprising:
a battery divided into an upper battery on a high voltage side and a lower battery on a low voltage side; and
a DC-DC converter for suppling power to the upper battery and the lower battery within preset output limits;
wherein
a feedback control is added to feed back a difference between a long-term average value of an output of the DC-DC converter and a target value.

2. The vehicle power supply device according to Claim 1, wherein
the DC-DC converter supplies the power by P (proportional control) I (integral control) D (derivative control) control;
the long-time average value of the feedback control is a longer time average than an I (integral control) control of the PID control.

3. The vehicle power supply device according to Claim 2, wherein
the upper battery is connected to the high voltage side and the lower battery is connected to a ground side;
the DC-DC converter supplies the power between the high voltage side and a connection point of the upper battery and the lower battery, and between the connection point and the ground side; and
the feedback control adds the difference between the long-time average value of the output of the DC-DC converter and the target value to an input side of the DC-DC converter.

4. The vehicle power supply device according to Claim 1, wherein
a voltage of the upper battery is approximately equal to a voltage of the lower battery.

5. The vehicle power supply device according to Claim 1, wherein
a voltage of the upper battery is higher than a voltage of the lower battery.

6. 7. The vehicle power supply device according to claim 5, wherein
the long-time average value is obtained by an arithmetic process.
